(19) **Europäisches Patentamt / European Patent Office / Office européen des brevets**

(11) **EP 1 047 174 B1**

(12) **FASCICULE DE BREVET EUROPEEN**

(45) Date de publication et mention
de la délivrance du brevet:
**12.08.2009 Bulletin 2009/33**

(51) Int Cl.:
*H02J 7/00* (2006.01)  *G01R 19/32* (2006.01)

(21) Numéro de dépôt: **99107883.3**

(22) Date de dépôt: **21.04.1999**

(54) **Circuit de protection pour batterie**

Batterieschutzschaltung

Battery protection circuit

(84) Etats contractants désignés:
**CH DE FR GB IT LI NL SE**

(43) Date de publication de la demande:
**25.10.2000 Bulletin 2000/43**

(73) Titulaire: **EM Microelectronic-Marin SA
2074 Marin (CH)**

(72) Inventeur: **Descombes, Arthur
3210 Kerzers (CH)**

(74) Mandataire: **Rossand, Isabelle et al
ICB
Ingénieurs Conseils en Brevets
Faubourg de l'Hôpital
2001 Neuchâtel (CH)**

(56) Documents cités:
**EP-A- 0 274 995      EP-A- 0 626 582
US-A- 5 057 779      US-A- 5 501 517
US-A- 5 689 209**

**Description**

La présente invention est relative à un circuit de protection pour batterie, et plus particulièrement à un circuit de protection pour batterie adapté pour protéger une batterie contre des courants de charge ou de décharge trop importants.

Dans le domaine des batteries rechargeables, il est connu des circuits de protection pour batterie au moyen desquels une surcharge de la batterie, non désirable pour des raisons de sécurité, peut être évitée. Il est par ailleurs connu des circuits de protection pour batterie au moyen desquels une surdécharge de la batterie peut également être évitée. En effet, en particulier dans le cas de batteries Li-ion (Lithium-ion), il peut être désirable d'éviter une telle surdécharge de la batterie qui aurait pour effet d'en dégrader la durée de vie. Typiquement, de tels circuits sont adaptés pour mesurer la tension aux bornes de la batterie et interrompre la charge ou la décharge de cette dernière en réponse à un signal indiquant que cette tension est supérieure ou respectivement inférieure à une limite prédéterminée.

Outre les fonctions de protection contre des surcharges ou des surdécharges, les circuits de protection pour batterie sont typiquement également adaptés pour protéger la batterie, en fonctionnement normal, c'est-à-dire lorsqu'il n'y a ni surcharge ni surdécharge de la batterie, contre des courants de charge ou de décharge trop importants. On parle alors communément de protection contre des surcourants.

Un tel circuit de protection pour batteries comporte typiquement des moyens d'interruption du courant connectés en série avec la batterie de sorte que lorsqu'une charge ou un chargeur sont connectés aux bornes de la batterie et des moyens d'interruption, un courant de décharge ou respectivement un courant de charge, de sens opposé, circule au travers de la batterie et des moyens d'interruption du courant. Les moyens d'interruption du courant doivent en conséquence être adaptés pour conduire et, le cas échéant, interrompre de manière bidirectionnelle le courant, c'est-à-dire soit lors de la charge ou de la décharge de la batterie.

La réalisation des moyens d'interruption du courant fait typiquement appel à des transistors MOS dont la conduction peut être aisément commandé par le biais de leur grille. En particulier, une première solution consiste à utiliser deux transistors MOSFET de puissance connectés en anti-série, c'est-à-dire source à source ou alternativement drain à drain. Ainsi, lorsqu'une condition de surcharge est détectée, l'un des transistors est coupé afin d'interrompre la circulation du courant de charge. De manière similaire, lorsqu'une condition de surdécharge est détectée, l'autre transistor est coupé afin d'interrompre la circulation du courant de décharge. On notera que lorsque l'un ou l'autre des transistors est coupé, la circulation d'un courant dans le sens opposé est toutefois permise, car tout transistor de puissance possède une diode parasite formée, en parallèle avec le canal, entre le drain et la source, de sorte que lorsqu'une condition de surdécharge est par exemple détectée, un courant de charge peut toutefois circuler au travers des transistors. En fonctionnement normal, c'est-à-dire en l'absence d'une condition de surcharge ou de surdécharge, les deux transistors sont conducteurs.

Alternativement, il a également été proposé d'utiliser un interrupteur bidirectionnel formé d'un unique transistor MOSFET pour réaliser cette fonction. Des exemples d'un tel interrupteur bidirectionnel sont présentés dans les brevets US-A-5 689 209 et US-A-5 581 170. Cette solution est particulièrement avantageuse car la résistance de conduction du transistor est divisée par deux par rapport à la solution utilisant deux transistors MOSFET de puissance branchés en anti-série. De plus, la surface nécessaire pour intégrer un tel interrupteur bidirectionnel est également moindre et permet en conséquence de réduire les coûts.

Afin de permettre la détection d'un surcourant, il est par exemple proposé de mesurer une chute de tension aux bornes d'une résistance de mesure disposée en série avec la batterie dans le chemin du courant de charge ou de décharge et d'interrompre la circulation du courant lorsque cette chute de tension dépasse une valeur prédéterminée. Cette solution n'est toutefois pas très adéquate car on désire généralement limiter la résistance présente en série avec la batterie dans le chemin du courant. De plus, il est relativement difficile de contrôler précisément la valeur de cette résistance lorsque celle-ci est réalisée de manière intégrée. Cette imprécision se répercute alors sur la valeur du courant de charge ou de décharge mesuré.

Une alternative proposée consiste à mesurer la tension aux bornes des moyens d'interruption du courant, cette tension étant représentative du courant de charge ou de décharge qui les traverse. Lorsque cette tension dépasse une tension de référence déterminée correspondant à une valeur limite de courant, les moyens d'interruption du courant sont ainsi activés afin de prévenir la circulation du courant au travers de la batterie. Les moyens d'interruption du courant étant typiquement réalisés, comme on l'a mentionné, au moyen d'une paire de transistor MOSFET de puissance montés en anti-série ou alternativement au moyen d'un unique transistor MOSFET, la tension mesurée à leurs bornes est ainsi représentative de la tension drain-source $V_{DS}$ du ou des tensions MOSFET. Pour un courant du drain $I_p$ donné, soit un courant de charge ou de décharge donné, cette tension $V_{DS}$ est notamment dépendante de la tension de grille $V_{GS}$ du transistor. Cette tension est de plus dépendante des caractéristiques propres au transistor, notamment la tension de seuil et la capacité de l'oxyde de grille du transistor. Cette tension est en outre sensiblement dépendante de la température.

Dans la demande de brevet EP 0 626 582, il est décrit un circuit pour détecter le niveau d'une tension d'entrée, qui possède des moyens de compensation de l'influence de la température. Le circuit est ainsi compensé en température de manière que l'excursion en tension reste stable dans une marge de température. Cependant ce circuit n'est pas destiné à être utilisé pour protéger une batterie rechargeable pour la commande de moyens d'interruption disposés en série avec la batterie, ce qui constitue un inconvénient.

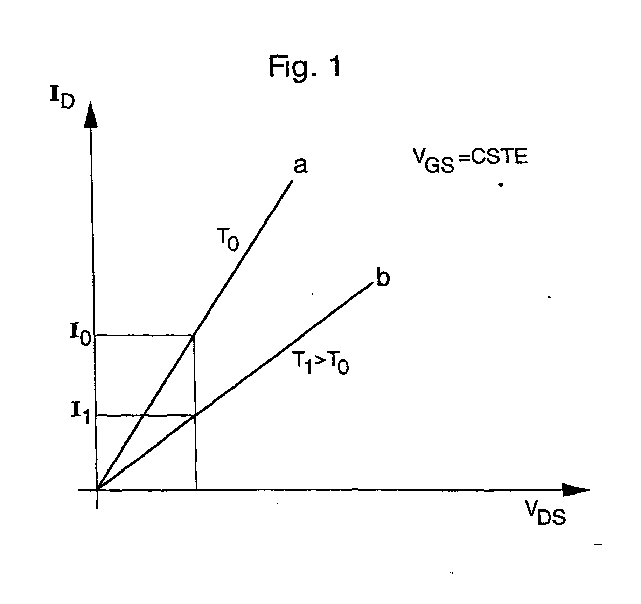

La figure 1 présente un diagramme des caractéristiques de sortie $I_D/V_{DS}$ d'un transistor MOS dans sa zone linéaire, c'est-à-dire pour des valeurs de tension drain-source $V_{DS}$ faibles et inférieurs à la tension de saturation du transistor et pour une valeur de tension de grille donnée $V_{GS}$ Dans cette figure sont illustrées deux courbes a et b. La courbe a illustre la caractéristique de sortie en zone linéaire du transistor pour une température nominale $T_0$. Suite à une élévation de la température à une température supérieur $T_1$, la caractéristique de sortie du transistor, pour la même tension de grille $V_{GS}$, telle qu'illustrée par la courbe b, a tendance à s'abaisser. On constate donc que pour une valeur de tension drain-source correspondant à un courant de drain $I_0$ donné à la température nominale $T_0$, cette tension est atteinte pour un courant de drain $I_1$ inférieur au courant $I_0$ lorsque la température augmente à $T_1$. En d'autres termes, la tension mesurée pour un courant donné, par exemple égal à un seuil de courant $I_{PROT}$, augmente avec la température. Ainsi, si l'on choisit, tel que cela est typiquement le cas, de fixer une tension de référence $V_{REF}$ représentative de ce seuil de courant $I_{PROT}$ et de comparer la tension mesurée à cette tension de référence, la valeur du courant réel différera selon la température.

De plus, la tension de référence $V_{REF}$ peut elle aussi varier sensiblement avec la température. En particulier, la tension de référence $V_{RRF}$ peut typiquement être plus fortement dépendante de la température que ne l'est la tension mesurée aux bornes des moyens d'interruption. Dans un tel cas de figure, le courant effectif peut dépasser le seuil de courant défini par la tension de référence avant que les moyens d'interruption ne soient activés pour interrompre la circulation du courant. A l'opposé, si la tension mesurée aux bornes des moyens d'interruption est plus fortement dépendante de la température que ne l'est la tension de référence $V_{REF}$, les moyens d'interruption risquent d'interrompre la circulation du courant alors que ce dernier est sensiblement inférieur au seuil de courant fixé.

Un but de la présente invention est ainsi de pallier à ces inconvénients et de proposer un circuit de protection pour batterie dans lequel la dépendance en température de la tension mesurée et/ou de la tension de référence, peut être compensée.

A cet effet, la présente invention a pour objet un circuit de protection pour batterie dont les caractéristiques sont énumérées à la revendication indépendante 1.

Des formes d'exécutions particulières du circuit de protection sont définies dans les revendications dépendantes 2 à 10.

D'autres caractéristiques et avantages de l'invention apparaîtront plus clairement à la lecture de la description détaillée qui suit, faite en référence aux dessins annexés donnés à titre d'exemples non limitatifs et dans lesquels :

- la figure 1 est un diagramme illustrant les caractéristiques de sortie $I_D/V_{DS}$ d'un transistor MOSFET dans la zone linéaire des caractéristiques pour deux températures distinctes $T_0$ et $T_1$;
- la figure 2 est un schéma bloc simplifié du circuit de protection pour batterie selon la présente invention;
- la figure 3 est un exemple de réalisation de moyens d'interruption du courant de charge ou de décharge;
- les figures 4a et 4b sont des diagrammes illustrant deux cas de figures de la dépendance en température de la tension de référence $V_{REF}$ et de la tension de mesure $V_M$;
- la figure 5 est un exemple de réalisation de moyens de comparaison du circuit de protection pour batterie selon la présente invention.

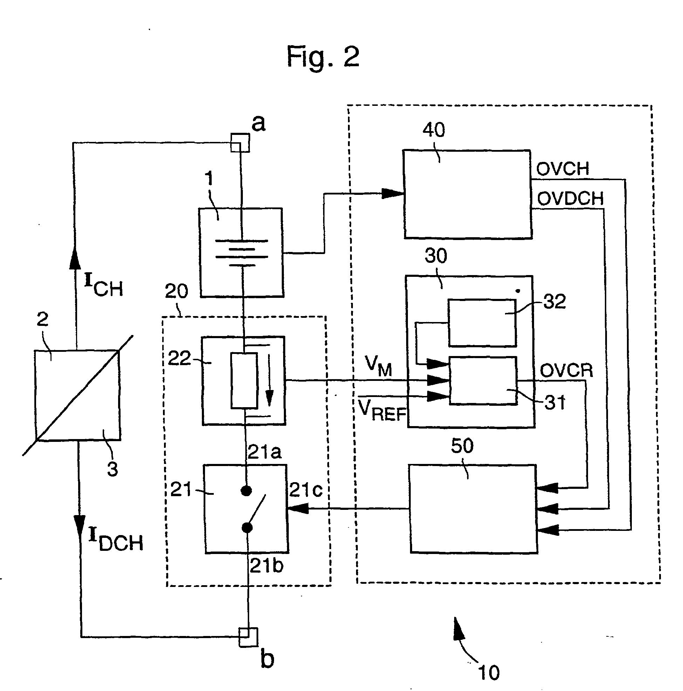

En référence à la figure 2, il est illustré de manière schématique un circuit de protection 10 pour batterie, selon la présente invention, associé à une batterie rechargeable 1. La batterie 1 et le circuit de protection 10 forment un ensemble comportant deux bornes a et b entre lesquelles peuvent être connectées une charge 2 ou un chargeur 3. Des moyens d'interruption du courant 21 sont disposés en série avec la batterie 1, entre les bornes a et b, de manière à pouvoir interrompre, si nécessaire, la circulation du courant au travers de celle-ci. Lorsqu'une charge 2 est connectée entre les bornes a et b, un courant de décharge $I_{DCH}$ circule de la borne positive de la batterie 1 via la charge 2 et les moyens d'interruption 21 jusqu'à la borne négative de la batterie 1. Lorsqu'un chargeur 3 est connecté entre les bornes a et b de l'ensemble, un courant de charge $I_{CH}$ circule dans le sens opposé au courant de décharge $I_{DCH}$.

Conformément à ce qui a déjà été mentionné en préambule, les moyens d'interruptions 21 sont adaptés, pour conduire et, le cas échéant, interrompre de manière bidirectionnelle le courant, c'est-à-dire soit lors de la charge ou de la décharge de la batterie 1. Ces moyens d'interruption 21 peuvent ainsi être schématisé comme un interrupteur comportant deux bornes 21a et 21b formant un chemin de conduction 21a-21b et une borne de commande 21c permettant d'interrompre ou non la circulation du courant entre ses bornes de conduction 21a et 21b.

En série avec la batterie 1, sont également connectés des moyens de mesure 22. Ces moyens de mesure 22 sont adaptés pour fournir une tension de mesure $V_M$ représentative du courant de charge $I_{CH}$ ou de décharge $I_{DCH}$ circulant au travers de la batterie.

Préférablement, comme cela est schématisé dans la figure 2 par le bloc indiqué par la référence numérique 20, les moyens d'interruption 21 forment également les moyens de mesure 22. La tension de mesure $V_M$ est ainsi représentative du courant de charge ou de décharge traversant les moyens d'interruption 21.

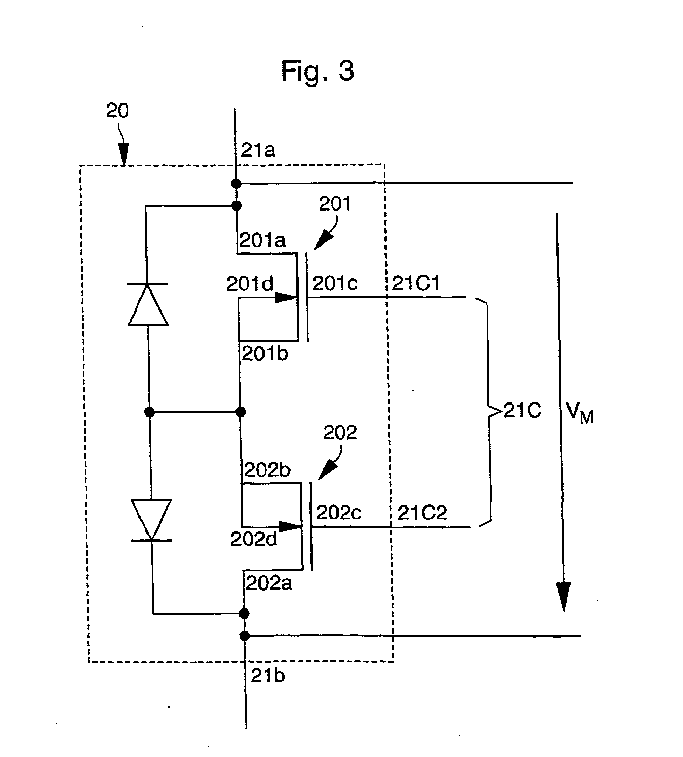

La figure 3 illustre un exemple de réalisation des moyens 20 comprenant les moyens d'interruption 21 et de mesure 22. Ceux-ci comprennent ainsi deux transistors MOSFET de puissance 201 et 202 connectés en anti-série source à source. Les sources 201b et 202b de ces transistors sont ainsi connectées en commun alors que les drains 201a et 202a forment respectivement les bornes de conduction 21a et 21b des moyens d'interruption 21. Les grilles 201c et 202c des transistors forment de plus des bornes de commande 21c1 et 21c2 des moyens d'interruptions 21, indiquées globalement par la référence numérique 21c. Chaque transistor de puissance est en outre caractérisé par le fait que la source est connectée à une contre-grille (ou "body"), 201d et 202d, respectivement, de sorte qu'une diode parasite apparaît entre source et drain.

Dans l'exemple de la figure 3, la tension de mesure $V_M$ est ainsi définie entre les bornes 21a et 21b des moyens d'interruption. Cette tension correspond ainsi, dans le cas présent, à la somme des tensions drain-source des transistors 201 et 202, mais par souci de simplification on peut considérer que les moyens 20 se comportent comme un seul transistor MOSFET. De plus, selon qu'un courant de charge $I_{CH}$ ou de décharge $I_{DCH}$ traverse les moyens 20, la tension de mesure $V_M$ est définie comme la différence de potentiel entre les bornes 21a et 21b ou la différence de potentiel entre les bornes 21b et 21a de sorte que la tension de mesure $V_M$ est toujours définie positive.

En se référant à nouveau à la figure 2, le circuit de protection 10 comprend plus particulièrement des moyens de détection et de comparaison 30 permettant de détecter si oui ou non le courant de charge $I_{CH}$ ou de décharge $I_{DCH}$ est supérieur à un seuil de courant déterminé $I_{PROT}$. Ces moyens de détection et de comparaison 30 sont ainsi adaptés pour recevoir la tension de mesure $V_M$ provenant des moyens de mesure 22 et une tension de référence $V_{REF}$ typiquement produite par une source de tension interne non représentée. Cette tension de référence $V_{REF}$ est représentative du seuil de courant $I_{PROT}$; elle est définie comme la tension de mesure $V_M$ correspondant à un courant égal au seuil de courant $I_{PROT}$ pour une température nominale $T_0$.

Les moyens de détection et de comparaison 30 comprennent typiquement un moyen de comparaison 31 entre la tension de mesure $V_M$ et la tension de référence $V_{REF}$ permettant de produire un signal de commande OVCR. Le signal de commande OVCR est ainsi représentatif du courant de charge $I_{CH}$ ou de décharge $I_{DCH}$ étant supérieur ou non au seuil de courant déterminé $I_{PROT}$.

Selon la présente invention, afin de compenser une dépendance en température de la tension de mesure $V_M$ et/ou de la tension de référence $V_{REF}$, les moyens de détection et de comparaison 30 comprennent en outre des moyens d'ajustement 32 pour fournir une valeur de compensation permettant de compenser la dépendance en température de la tension de mesure $V_M$ et/ou de la tension de référence $V_{REF}$. Ces moyens d'ajustement 32 seront décrits ultérieurement de manière plus détaillée.

Le circuit de protection 10 comprend par ailleurs typiquement des moyens de détection 40 d'une surcharge et/ou d'une surdécharge de la batterie 1. Ces moyens sont typiquement connectés entre les bornes de la batterie 1 de manière à surveiller le niveau de tension de cette dernière, et produisent, en réponse à un condition de surcharge ou de surdécharge déterminée, un signal de surcharge OVCH ou de surdécharge OVDCH. On ne rentrera pas plus en détail dans la réalisation de ces moyens de détection 40 d'une surcharge et/ou surdécharge, l'homme du métier étant parfaitement à même de réaliser ces derniers de la manière adéquate.

Le circuit de protection 10 comprend par ailleurs typiquement des moyens de commande 50 connectés à la ou les bornes de commandes des moyens d'interruption 21, et recevant les signaux de commande OVCR, de surcharge OVCH, et de surdécharge OVDCH. Ces moyens de commande 50 sont typiquement adaptés pour commander les moyens d'interruption 21 de manière à interrompre la circulation du courant au travers de la batterie 1 en réponse aux signaux de commande OVCR, de surcharge OVCH ou de surdécharge OVDCH.

Comme on l'a déjà mentionné en préambule, la tension de mesure $V_M$, pour un courant donné, ainsi que la tension de référence $V_{REF}$ peuvent tout deux présenter une dépendance en température. En conséquence, une simple comparaison entre la tension de mesure et la tension de référence peut aboutir, selon la température, à un signal de commande OVCR erroné, c'est-à-dire un signal de commande OVCR qui ne correspond pas effectivement à la condition de surcourant déterminée.

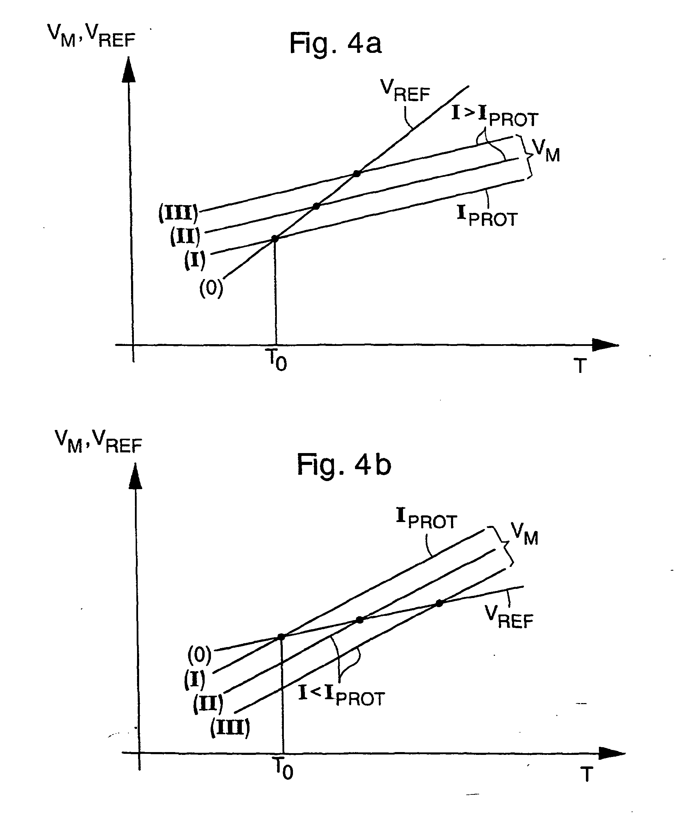

Les figures 4a et 4b permettent de mieux illustrer les risques potentiels d'une comparaison, sans compensation en température, entre la tension de mesure $V_M$, pour un courant donné, et la tension de référence $V_{REF}$. Les figures 4a et 4b représentent ainsi des diagrammes illustrant l'évolution, en fonction de la température et dans les deux cas de figure pouvant essentiellement se présenter, de la tension de mesure $V_M$, pour un courant de charge $I_{CH}$ ou de décharge $I_{DCH}$ donné, et de la tension de référence $V_{REF}$.

Ces figures permettent d'illustrer la dépendance en température de chacune de ces tensions. On rappellera que la tension de référence $V_{REF}$ est définie, à une température nominale $T_0$, comme la tension de mesure $V_M$ aux bornes des moyens d'interruption 21 correspondant à un courant de charge $I_{CH}$ ou de décharge $I_{DCH}$ égal au seuil de courant $I_{PROT}$.

Dans chaque figure sont illustrées une courbe (o) représentative de l'évolution de la tension de référence $V_{REF}$ ainsi que trois courbes (i) à (iii) représentatives de l'évolution de la tension de mesure $V_M$ pour trois courants différents, la courbe (i) étant représentative, dans les deux figures, de la tension de mesure $V_M$ pour un courant équivalent au seuil de courant $I_{PROT}$. On à supposé ici que les courbes d'évolution (o) et (i) à (iii) sont sensiblement linéaires et présentent typiquement un coefficient de température positif, c'est-à-dire une tension augmentant avec la température.

La figure 4a illustre un premier cas de figure où la tension de référence $V_{REF}$ est plus sensiblement dépendante de la température que ne l'est la tension de mesure $V_M$ pour un courant donné. Les courbes (ii) et (iii) sont représentatives de deux tensions de mesures $V_M$ pour deux courants supérieurs au seuil de courant $I_{PROT}$. On peut ainsi constater que si, pour une température nominale $T_0$, la tension de mesure $V_M$ correspond bien à la tension de référence $V_{REF}$ pour un courant égal à $I_{PROT}$ (courbe (i)), cette équivalence, pour des températures allant en augmentant, est atteinte pour des tensions de mesure $V_M$ correspondant à des courants de drain allant également en augmentant (courbes (ii) et (iii)). Il n'est bien évidemment nullement souhaitable que le seuil de courant réel évolue de sorte qu'il augmente avec la température.

La figure 4b illustre un deuxième cas de figure où la tension de référence $V_{REF}$ est moins sensiblement dépendante de la température que ne l'est la tension de mesure $V_M$ pour un courant donné. Les courbes (ii) et (iii) sont représentatives de deux tensions de mesures $V_M$ correspondant à deux courants inférieurs au seuil de courant $I_{PROT}$. Dans ce cas de figure, on peut donc constater que pour des températures allant en augmentant, l'équivalence entre la tension de mesure $V_M$ et la tension de référence $V_{REF}$ est atteinte pour des tensions de mesure correspondant à des courants de drain allant en diminuant (courbes (ii) et (iii)). Ce cas de figure apparaît plus favorable que le précédant, mais on désirera toutefois éviter que le seuil de courant réel diminue trop fortement lorsque la température augmente afin de ne pas couper inutilement la circulation du courant dans la batterie.

Analytiquement, la dépendance en température de la tension de référence $V_{REF}$ et de la tension de mesure $V_M$, pour un courant donné égal au seuil de courant $I_{PROT}$, peut être exprimée comme suit :

$$\Delta V = V_{REF} - V_M = \kappa (T - T_0) \qquad (1)$$

où $\kappa$ est un facteur de dépendance en température défini positif ou négatif selon le cas de figure considéré, à savoir le cas de figure présenté en référence à la figure 4a ou le cas de figure présenté en référence à la figure 4b. Ce facteur de dépendance en température $\kappa$ est déterminé par une première dépendance en température de la tension de mesure $V_M$ et une seconde dépendance en température de la tension de référence $V_{REF}$.

Selon la présente invention, les moyens de détection et de comparaison 30 sont adaptés pour compenser la dépendance en température des tensions de mesure $V_M$ et de référence $V_{REF}$. Les moyens de détection et de comparaison 30 comprennent ainsi des moyens d'ajustement 32 pour produire une valeur de compensation déterminée et permettant de compenser la dépendance en température des tensions de mesure $V_M$ et de référence $V_{REF}$.

Pour réaliser ces moyens d'ajustement 32, on utilise préférablement des transistors bipolaires branchés en diode, c'est-à-dire des transistors bipolaires dont la base et le collecteur sont reliés ensemble. On sait que la tension $V_D$ aux bornes d'une diode constituée par la jonction base-émetteur d'un transistor bipolaire suit une évolution sensiblement linéaire en fonction de la température et présente avantageusement un coefficient de température négatif, c'est-à-dire qu'elle décroît linéairement lorsque la température augmente. Lorsque la température tend vers 0° K, cette tension de diode tend vers une valeur $V_{BG}$ dénommée valeur bandgap. Dans le cas du silicium, cette valeur bandgap équivaut environ à 1,205 Volts. Cette tension de diode $V_D$ est sensiblement égale à :

$$V_D = V_{BG} - kT/e \ln (I_0/I) \qquad (2)$$

où $k$ est la constante de Boltzmann, $e$ la charge de l'électron et $I_0$ une valeur dépendant notamment de la surface du dispositif et des concentrations équivalentes des états de conduction et de valence du matériau dopé.

La valeur $I_0$ est très supérieure à celle du courant $I$ qui traverse la diode; bien qu'elle dépende de la technologie de fabrication du transistor et également de la température, on peut considérer que le facteur $\ln (I_0/I)$ reste sensiblement constant pour un courant $I$ donné.

Si l'on fait passer successivement, dans une même diode, à une même température, deux courants différents $I_1$ et $I_2$, la différence $\Delta V_{21}$ entre les tensions $V_2$ et $V_1$ qui apparaissent à ses bornes est égale à :

5

$$\Delta V_{21} = V_2 - V_1 = kT/e \ \ln (I_2/I_1) \qquad\qquad (3)$$

Cette différence est directement dépendante de la température est présente un coefficient de température positif ou négatif selon que le courant $I_2$ est supérieur ou inférieur au courant $I_1$.

Par ailleurs, en ajoutant une tension proportionnelle à cette différence à une tension de diode $V_3$ produite par le passage d'un courant $I_3$, pour une même température, on obtient :

$$V_3 + \gamma \ \Delta V_{21} = V_{BG} - kT/e \left( \ln (I_0/I_3) - \gamma \ \ln (I_2/I_1) \right) \qquad\qquad (4)$$

Par un choix adéquat du coefficient de proportionnalité $\gamma$ tel que l'on ait :

$$\ln (I_0/I_3) - \gamma \ \ln (I_2/I_1) = 0 \qquad\qquad (5)$$

la quantité $V_3 + \gamma \Delta V_{21}$ peut ainsi être rendue indépendante de la température et équivaut alors à la valeur bandgap $V_{BG}$.

Ainsi en ajoutant une tension proportionnelle à la différence $\Delta V_{21}$ entre deux tensions de diode ainsi qu'une tension proportionnelle à la valeur bandgap $V_{BG}$ à la différence $\Delta V$ entre les tensions de référence $V_{REF}$ et de mesure $V_M$ telle qu'exprimée sous (1), on obtient :

$$\Delta V + \alpha \ \Delta V_{21} + \beta \ V_{BG} = \left( \kappa + \alpha \ k/e \ \ln (I_2/I_1) \right) T + \beta \ V_{BG} - \kappa \ T_0 \quad (6)$$

Par un choix adéquat des coefficients de proportionnalité $\alpha$ et $\beta$ tel que l'on ait :

$$\kappa + \alpha \ k/e \ \ln (I_2/I_1) = 0 \quad \text{et} \quad \beta \ V_{BG} - \kappa \ T_0 = 0 \qquad\qquad (7)$$

la dépendance en température des tensions de mesure $V_M$ et de référence $V_{REF}$ peut être entièrement compensée. En d'autres termes, la quantité $\Delta V + \alpha \ \Delta V_{21} + \beta \ V_{BG}$ peut être rendue indépendante de la température. Cette quantité s'annulera ainsi quelque soit la température pour une tension de mesure $V_M$ correspondant à un courant de charge ou de décharge équivalent à $I_{PROT}$.

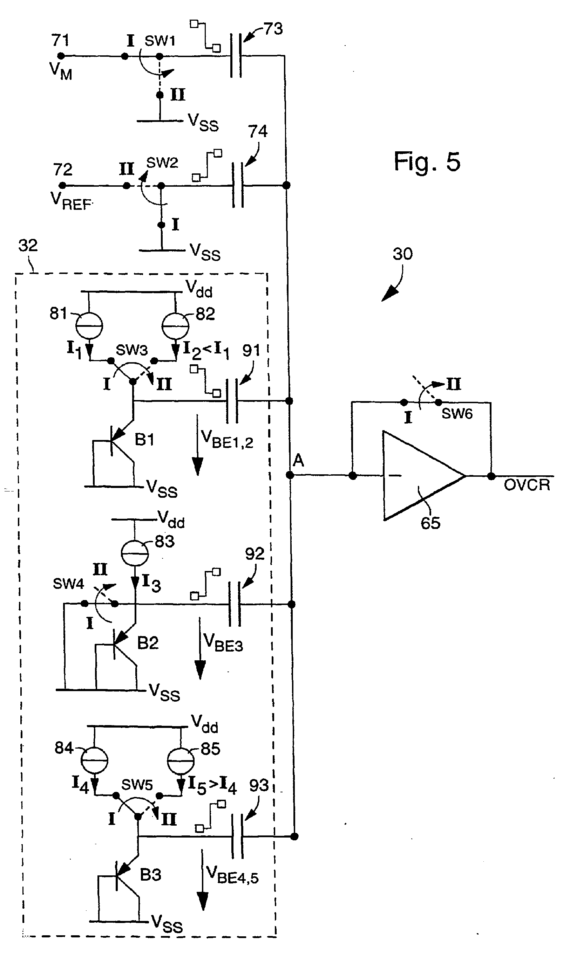

La figure 5 présente un exemple de réalisation des moyens de détection et de comparaison 30 permettant de mettre en oeuvre les principes qui viennent d'être énoncés pour le cas de figure présenté en référence à la figure 4a, à savoir dans le cas où la tension de référence $V_{REF}$ est plus sensiblement dépendante de la température que ne l'est la tension de mesure $V_M$ pour un courant donné.

Les moyens de détection et de comparaison 30 comprennent ainsi deux entrées 71 et 72 sur lesquelles sont respectivement appliquées la tension de mesure $V_M$ et la tension de référence $V_{REF}$. Deux éléments capacitifs 73 et 74 sont respectivement disposés sur ces entrées 71 et 72. Ces éléments capacitifs 73 et 74 sont adaptés pour être reliés respectivement aux entrées 71 et 72 du circuit par l'intermédiaire d'un commutateur SW1 et d'un commutateur SW2 respectivement. Lorsque les commutateurs SW1 et SW2 sont positionnés en "I", tel que cela est indiqué par des traits pleins, les éléments capacitifs 73 et 74 sont respectivement connectés à l'entrée 71 sur laquelle est appliquée la tension de mesure $V_M$ et à une borne d'alimentation du circuit sur laquelle est appliqué un potentiel Vss définissant une masse (potentiel zéro) du circuit de détection. Lorsqu'ils sont positionnés en "II", tel que cela est indiqué par les pointillés, les éléments capacitifs 73 et 74 sont alors respectivement connectés à la masse et à l'entrée 72 sur laquelle est appliquée la tension de référence $V_{REF}$. Alternativement, on notera qu'il est possible de n'utiliser qu'un seul élément capacitif et un seul commutateur adapté pour commuter successivement entre les bornes d'entrée 71, en position "I", et 72, en position "II".

Les autres bornes des éléments capacitifs 73, 74 sont reliées ensemble à un noeud A à l'entrée inverseuse d'un amplificateur 65 à gain très élevé. Un commutateur SW6 permet de relier ou non la sortie de l'amplificateur 65 à son entrée. Les capacités respectives des éléments capacitifs 73 et 74 sont choisies égale (capacité C) de sorte que les tensions de mesure $V_M$ et de référence $V_{REF}$ sont directement comparées.

Selon la présente invention, les moyens de détection et de comparaison 30 comprennent des moyens d'ajustement, indiqués globalement par la référence 32, pour produire une valeur de compensation dépendante de la température et permettant de compenser la dépendance en température des tensions de mesure $V_M$ et de référence $V_{REF}$.

Ces moyens d'ajustement 32 pour produire la valeur de compensation comportent, dans l'exemple de la figure 5, trois transistors bipolaires B1, B2, B3 de type PNP branchés en diode. Ces trois transistors bipolaires sont reliés par leur collecteur et leur base à la masse circuit de détection.

Des première et seconde sources de courants 81 et 82 produisant respectivement des courants $I_1$ et $I_2$ sont disposées entre l'émetteur du transistor B1 et une borne d'alimentation du circuit sur laquelle est appliquée un potentiel Vdd. Ces sources de courant 81 et 82 sont reliées sélectivement à l'émetteur du transistor B1 au moyen d'un commutateur SW3 de sorte que la jonction base-émetteur du transistor est traversée sélectivement par les courants $I_1$ ou $I_2$ lorsque le commutateur SW3 est en position "I" ou en position "II". En conséquence des tensions de diodes $V_{BE1}$ et $V_{BE2}$ sont sélectivement produites. Dans cet exemple, le courant $I_2$ est défini de sorte qu'il soit inférieur au courant $I_1$, la tension de diode $V_{BE2}$ étant ainsi inférieure à la tension de diode $V_{BE1}$.

Une troisième source de courant 83 est disposée entre l'émetteur du transistor B2 et la borne d'alimentation du circuit sur laquelle est appliquée le potentiel Vdd. Cette source de courant 83 maintient un courant $I_3$ constant au travers de la jonction base-émetteur du transistor B2. Un commutateur SW4 est par ailleurs disposé entre l'émetteur du transistor B2 et la masse du circuit. Lorsque ce commutateur SW4 est en position "I", indiquée par les traits pleins, l'émetteur du transistor B2 est ainsi relié à la masse du circuit. Dans le cas contraire, lorsque ce commutateur est en position "II", indiquée par les pointillés, la jonction base-émetteur est traversée par le courant $I_3$ et une tension de diode $V_{BE3}$ est ainsi produite.

Des quatrième et cinquième sources de courants 84 et 85 produisant respectivement des courants $I_4$ et $I_5$ sont en outre disposées entre la borne Vdd du circuit et l'émetteur du transistor B3. Ces sources de courant 84 et 85 sont reliées sélectivement à l'émetteur du transistor B3 au moyen d'un commutateur SW5 de sorte que la jonction base-émetteur du transistor est traversée sélectivement par les courants $I_4$ ou $I_5$ lorsque le commutateur SW5 est en position "I" ou "II" respectivement. En conséquence des tensions de diodes $V_{BE4}$ et $V_{BE5}$ sont sélectivement produites. Dans cet exemple, le courant $I_4$ est défini de sorte qu'il soit inférieur au courant $I_5$, la tension de diode $V_{BE4}$ étant ainsi inférieure à la tension de diode $V_{BE5}$.

Trois éléments capacitifs 91, 92 et 93 sont en outre respectivement reliés par l'une de leurs bornes aux émetteurs des transistors B1, B2 et B3, les autres bornes de ces éléments capacitifs 91, 92, 93 étant reliés au noeud A d'entrée de l'amplificateur 65.

Les capacités respectives $C_1$ et $C_2$ des éléments capacitifs 91 et 92 sont telles que les rapport $C_1/C$ et $C_2/C$ (où C est la capacité des éléments capacitifs 73 et 74) sont très sensiblement égal au coefficient de proportionnalité $\alpha$ et $\beta$, respectivement, définis conformément aux expressions (6) et (7) ci-dessus. La capacité $C_3$ de l'élément capacitif 93 est telle que le rapport $C_3/C_2$ est très sensiblement égal au coefficient de proportionnalité $\gamma$ défini conformément aux expressions (4) et (5) ci-dessus.

Lors d'une première phase, les commutateurs SW1 à SW6 sont placés en position "I" indiquée en traits pleins sur la figure. L'amplificateur 65 est alors soumis à une contre-réaction totale et se polarise automatiquement à un point de fonctionnement stable, sa tension d'entrée $V_E$ étant alors égale à sa tension de sortie et son gain maximal. Les éléments capacitifs 73, 74 et 91, 92, 93 se chargent ainsi respectivement aux tensions $(V_E - V_M)$, $V_E$, $(V_E - V_{BE1})$, $V_E$ et $(V_E - V_{BE4})$.

Dans une deuxième phase, lorsque les commutateurs SW1 à SW6 sont placés en position "II" représentée en pointillés sur la figure, les éléments capacitifs 73, 74 et 91, 92, 93 injectent dans le noeud A d'entrée de l'amplificateur 65, laissé flottant, des charges électriques respectivement égale à $C V_M$, $C V_{REF}$, $\alpha C (V_{BE2} - V_{BE1})$, $\beta C V_{BE3}$, et $\beta\gamma C (V_{BE5} - V_{BE4})$, les charges injectées par les éléments capacitifs 73 et 91 étant de signe contraire aux autres charges dans ce cas de figure.

La somme totale des charges injectées par les éléments capacitifs 73, 74 et 91, 92, 93 dans le noeud A d'entrée de l'amplificateur 65 est ainsi représentative de l'expression (6) ci-dessus et équivaut à :

$$C \left( V_{REF} - V_M + \alpha \left( V_{BE2} - V_{BE1} \right) + \beta \left( V_{BE3} + \gamma \left( V_{BE5} - V_{BE4} \right) \right) \right) \qquad (8)$$

où les coefficients de proportionnalité $\alpha$, $\beta$ et $\gamma$ sont tels que l'on ait, conformément aux expressions (5) et (7) :

$$\kappa + \alpha\, k/e\, \ln(I_2/I_1) = 0, \quad \beta\, V_{BG} - \kappa\, T_0 = 0, \quad \ln(I_0/I_3) - \gamma \ln(I_5/I_4) = 0 \quad (9)$$

où κ est défini comme le facteur de dépendance en température défini positif dans ce cas de figure et déterminé par la dépendance en température de la tension de référence $V_{REF}$ et de la tension de mesure $V_M$, pour un courant donné égal au seuil de courant $I_{PROT}$ (expression (1) ci-dessus).

Pour un courant de charge $I_{CH}$ ou de décharge $I_{DCH}$ équivalent au seuil de courant $I_{PROT}$, la somme totale des charges injectées dans le noeud A de l'amplificateur 65 s'annule ainsi, quelque soit la température et il n'apparaît aucun signal à l'entrée de l'amplificateur 65.

Par contre, si le courant de charge ou de décharge est différent du seuil de courant $I_{PROT}$, c'est-à-dire si la tension de mesure $V_M$ est différente de la tension de mesure $V_M$ correspondant à un courant équivalent à $I_{PROT}$, il apparaît à l'entrée de l'amplificateur 65 une variation de tension dont la polarité est représentative du signe de la charge totale injectée dans le noeud A d'entrée. Ce signal est amplifié et inversé par l'amplificateur 65 qui fournit un signal de sortie d'amplitude très supérieure à celle du signal appliqué à son entrée. Ce signal de sortie de l'amplificateur 65, de niveau logique, peut ainsi être utilisé comme le signal de commande OVCR afin de commander les moyens d'interruption 21 et d'interrompre le cas échéant la circulation du courant de charge $I_{CH}$ ou de décharge $I_{DCH}$.

Préférablement, on cherchera, comme on peut le comprendre de ce qui précède, à annuler sensiblement la dépendance en température des tensions de mesure $V_M$ et de référence $V_{REF}$ de sorte que le courant de charge $I_{CH}$ ou de décharge $I_{DCH}$ ne puisse dépasser le seuil de courant $I_{PROT}$ défini. Dans un tel cas, le signal de commande OVCR produit par les moyens de détection et de comparaison 30 sera donc indépendant de la température.

Il peut toutefois être envisagé, dans le cadre de la présente invention, de compenser la dépendance en température des tensions de mesure $V_M$ et de référence $V_{REF}$ de sorte que la limite effective de courant évolue légèrement de manière négative avec la température. Il peut en effet être préférable de s'assurer que l'on se trouve dans le cas de figure présenté plus haut en référence à la figure 4b de telle sorte que le seuil effectif de courant n'évolue en aucun cas de manière positive avec la température. Dans un tel cas, le signal de commande OVCR produit par les moyens de détection et de comparaison 30 présentera donc un coefficient de température négatif.

On remarquera ainsi que le circuit de protection selon la présente invention offre avantageusement une grande flexibilité d'ajustement. On constate en outre de ce qui précède que le circuit selon la présente invention présente l'avantage de pouvoir compenser aisément et précisément la dépendance en température de la tension de référence $V_{REF}$ et de la tension de mesure $V_M$, pour un courant donné. Il est par exemple très aisé de réaliser en technologie MOS des rapports de capacités très précis pour les éléments capacitifs.

Le circuit selon la présente invention fonctionne en outre de façon très rapide, le temps nécessaire au calcul et à la comparaison étant essentiellement consacré à la phase de charge de éléments capacitifs et de polarisation de l'amplificateur.

De plus, l'amplificateur 65 ne sert en fait qu'à amplifier suffisamment le signal apparaissant au noeud A d'entrée de sorte que le signal de commande OVCR puisse attaquer correctement les moyens de commande 50 des moyens d'interruption 21. On peut donc se contenter d'utiliser un amplificateur à un seul étage réalisé, à la manière d'un inverseur, par deux transistors complémentaires montés en source commune dont les drains sont reliés entre eux.

On peut par ailleurs remarquer dans ce qui précède qu'il n'est pas nécessaire de produire effectivement les trois tensions $V_{BE3}$, $V_{BE4}$ et $V_{BE5}$, deux tensions suffisent. Il est ainsi possible de s'affranchir du transistor B2, et d'utiliser comme tension $V_{BE3}$, la tension $V_{BE5}$ produite par le transistor B3 lors de la seconde phase. Dans ce cas, l'élément capacitif 92 peut être connecté, par l'intermédiaire d'un commutateur tout d'abord à la masse du circuit lors de la première phase puis, lors de la deuxième phase, à l'émetteur du transistor B3.

### Revendications

**1.** Circuit de protection (10) destiné à protéger une batterie rechargeable (1) pouvant être traversée par un courant de charge ou de décharge ($I_{CH}$, $I_{DCH}$), ce circuit de protection (10) comprenant :

- des moyens de mesure (22) adaptés pour être connectés en série avec ladite batterie (1) et fournir une tension de mesure ($V_M$) représentative dudit courant ($I_{CH}$, $I_{DCH}$), cette tension de mesure ($V_M$) pouvant présenter une première dépendance en température,
- des moyens de détection et de comparaison (30, 31, 32) adaptés pour recevoir ladite tension de mesure ($V_M$) et une tension de référence ($V_{REF}$), et produire, en réponse à une comparaison desdites tensions de référence ($V_{REF}$) et de mesure ($V_M$), un signal de commande (OVCR), cette tension de référence ($V_{REF}$) pouvant présenter une seconde dépendance en température; et
- des moyens d'interruption (21) adaptés pour commander la circulation dudit courant ($I_{CH}$, $I_{DCH}$) au travers de ladite batterie (1) en réponse audit signal de commande (OVCR),
ce circuit de protection (10) étant **caractérisé en ce que** lesdits moyens de détection et de comparaison (30, 31, 32) comprennent

- des moyens d'ajustement (32), comprenant des moyens de production de tensions de diode ($V_{BE1}$ à $V_{BE5}$), pour fournir une valeur de compensation permettant de compenser ladite première dépendance en température de la tension de mesure ($V_M$) et/ou ladite seconde dépendance en température de la tension de référence ($V_{REF}$), et

- des moyens de calcul comprenant des éléments capacitifs (73, 74, 91, 92, 93) et des organes de commutations (SW1 à SW6) pour relier sélectivement et séquentiellement, lors d'une première phase et d'une seconde phase, lesdits éléments capacitifs (73, 74, 91, 92, 93) auxdits moyens de production des tensions de diode ($V_{BE1}$ à $V_{BE5}$) et à des bornes (71, 72) sur lesquelles sont appliquées lesdites tensions de mesure ($V_M$) et de référence ($V_{REF}$), de sorte que lesdits moyens de calcul produisent, au cours de ladite seconde phase, ledit signal de commande (OVCR), et

**en ce que** lesdits moyens d'ajustement produisent une valeur de compensation définie à partir de la somme :

- du produit de la différence entre des première et seconde tensions de diode ($V_{BE1}$, $V_{BE2}$) par un premier coefficient déterminé ($\alpha$), et

- du produit, par un second coefficient déterminé ($\beta$), de la somme d'une troisième tension de diode ($V_{BE3}$) et du produit de la différence entre des quatrième et cinquième tensions de diode ($V_{BE4}$, $V_{BE5}$) par un troisième coefficient déterminé ($\gamma$), ledit signal de commande (OVCR) étant représentatif de la somme de la différence entre lesdites tensions de référence ($V_{REF}$) et de mesure ($V_M$), et de ladite valeur de compensation.

2. Circuit de protection selon la revendication 1, **caractérisé en ce que** lesdits moyens d'interruption (21) forment également lesdits moyens de mesure (22), ladite tension de mesure ($V_M$) étant alors représentative du courant ($I_{CH}$, $I_{DCH}$) traversant lesdits moyens d'interruption (21).

3. Circuit de protection selon la revendication 1, **caractérisé en ce que** lesdits moyens de calcul sont agencés pour produire :

- un premier signal représentatif de la différence entre lesdites tensions de référence ($V_{REF}$) et de mesure ($V_M$):
- un second signal représentatif du produit de la différence entre lesdites première et seconde tensions de diode ($V_{BE1}$. $V_{BE2}$) par ledit premier coefficient déterminé ($\alpha$);
- un troisième signal représentatif du produit de ladite troisième tension de diode ($V_{BE3}$) par ledit second coefficient déterminé ($\beta$); et
- un quatrième signal représentatif du produit de la différence entre lesdites quatrième et cinquième tensions de diode ($V_{BE4}$, $V_{BE5}$) par lesdits seconds et troisième coefficients déterminés ($\beta$ et $\gamma$),
ces signaux étant ensuite additionnés algébriquement pour produire ledit signal de commande (OVCR).

4. Circuit de protection selon la revendication 3, **caractérisé en ce que** lesdits moyens de calcul comportent :

- pour produire ledit premier signal, un premier élément capacitif (73, 74) de capacité déterminée,
- pour produire ledit second signal, un second élément capacitif (91) de capacité sensiblement égale au produit de la capacité dudit premier élément capacitif (73, 74) par ledit premier coefficient déterminé ($\alpha$),
- pour produire ledit troisième signal, un troisième élément capacitif (92) de capacité sensiblement égale au produit de la capacité dudit premier élément capacitif (73, 74) par ledit second coefficient déterminé ($\beta$), et
- pour produire ledit quatrième signal, un quatrième élément capacitif (93) de capacité sensiblement égale au produit de la capacité dudit premier élément capacitif (73, 74) par lesdits second et troisième coefficients déterminés ($\beta$ et $\gamma$).

5. Circuit de protection selon l'une des revendication 1 à 4, **caractérisé en ce que** lesdits moyens pour produire lesdites tensions de diode ($V_{BE1}$ à $V_{BE5}$) comportent des transistors bipolaires branchés en série avec des sources de courants et dont la base est reliée au collecteur.

6. Circuit de protection selon l'une des revendication 1 à 4, **caractérisé en ce que** lesdits moyens pour produire lesdites tensions de diode ($V_{BE1}$ à $V_{BE5}$) comportent trois transistors bipolaires (B1, B2, B3) dont la base est reliée au collecteur, des premier (B1) et deuxième (B3) desdits transistors étant chacun branché successivement en série avec deux sources de courant (81, 82 et 84, 85), un troisième (B2) desdits transistors étant branché en série avec une source de courant (83).

7. Circuit de protection selon l'une des revendication 1 à 4, **caractérisé en ce que** lesdits moyens pour produire lesdites tensions de diode ($V_{BE1}$ à $V_{BE5}$) comportent deux transistors bipolaires dont la base est reliée au collecteur, chacun desdits transistors étant branché successivement en série avec deux sources de courant.

**EP 1 047 174 B1**

**8.** Circuit de protection selon l'une des revendications 1 à 7, **caractérisé en ce que** lesdits moyens d'interruption (21) sont formés d'une paire de transistors MOSFET de puissance (201, 202) connectés en anti-série source à source, l'un ou l'autre des transistors (201, 202) étant coupé pour interrompre la circulation dudit courant ($I_{CH}$, $I_{DCH}$).

**9.** Circuit de protection selon l'une des revendications 1 à 7, **caractérisé en ce que** lesdits moyens d'interruption (21) sont formés d'une paire de transistors MOSFET de puissance connectés en anti-série drain à drain, l'un ou l'autre des transistors étant coupé pour interrompre la circulation dudit courant ($I_{CH}$, $I_{DCH}$).

**10.** Circuit de protection selon l'une des revendications 1 à 7, **caractérisé en ce que** lesdits moyens d'interruptions (21) sont formés d'un transistor MOSFET comprenant un terminal de contre-grille adapté pour être sélectivement connecté à la source ou au drain dudit transistor.

**Claims**

**1.** Protective circuit (10) for protecting a rechargeable battery (1) through which a charge or discharge current ($I_{CH}$, $I_{DCH}$) can pass, this protective circuit (10) including :

- measuring means (22) adapted to be connected in series with said battery (1) and to provide a measuring voltage ($V_M$) representative of said current ($I_{CH}$, $I_{DCH}$), said measuring voltage ($V_M$) being able to have a first temperature dependence;
- detection and comparison means (30, 31, 32) adapted to receive said measuring voltage ($V_M$) and a reference voltage ($V_{REF}$) and to generate a control signal (OVCR), in response to a comparison of said reference and measuring voltages ($V_{REF}$, $V_M$), said reference voltage ($V_{REF}$) being able to have a second temperature dependence; and
- interruption means (21) adapted to control the flow of said current ($I_{CH}$, $I_{DCH}$) through said battery (1) in response to said control signal (OVCR),
this protective circuit (10) being **characterised in that** said detection and comparison means (30, 31, 32) include
- adjustment means (32), which include means for generating diode voltages ($V_{BE1}$ to $V_{BE5}$), in order to supply a compensation value allowing to compensate said first temperature dependence of the measuring voltage ($V_M$) and/or said second temperature dependence of the reference voltage ($V_{REF}$), and
- calculating means including capacitive elements (73, 74, 91, 92. 93) and switching elements (SW1 to SW6) to connect selectively and sequentially, during a first and a second phase, said capacitive elements (73, 74, 91, 92, 93) to said means for generating said diode voltages ($V_{BE1}$ to $V_{BE5}$) and to terminals (71, 72) to which are applied said measuring voltage ($V_M$) and said reference voltage ($V_{REF}$), so that said calculating means generate, during said second phase, said control signal (OVCR),
and **in that** said adjustment means generate a compensation value defined from the sum :
- of the product of the difference between first and second diode voltages ($V_{BE1}$, $V_{BE2}$) by a first determined coefficient ($\alpha$), and
- of the product by a second determined coefficient ($\beta$), of the sum of a third diode voltage ($V_{BE3}$) and the product of the multiplication of the difference between fourth and fifth diode voltages ($V_{BE4}$, $V_{BE5}$) by a third determined coefficient ($\gamma$), said control signal (OVCR) being representative of the sum of the difference between said reference voltage ($V_{REF}$) and said measuring voltage ($V_M$), and of said compensation value.

**2.** Protective circuit according to claim 1, **characterised in that** said interruption means (21) also form said measuring means (22), said measuring voltage ($V_M$) being thus representative of the current ($I_{CH}$, $I_{DCH}$) passing through said interruption means (21).

**3.** Protective circuit according to claim 1, **characterised in that** said calculating means are arranged to generate:

- a first signal representative of the difference between said reference voltage ($V_{REF}$) and said measuring voltage ($V_M$);
- a second signal representative of the product of the difference between said first and second diode voltages ($V_{BE1}$, $V_{BE2}$) by said first determined coefficient ($\alpha$);
- a third signal representative of the product of said third diode voltage ($V_{BE3}$) by said second determined coefficient ($\beta$); and
- a fourth signal representative of the product of the difference between said fourth and fifth diode voltages ($V_{BE4}$, $V_{BE5}$) by said second and third determined coefficients ($\beta$ and $\gamma$), said signals being then added alge-

**10**

braically to generate said control signal (OVCR).

4. Protective circuit according to claim 3, **characterised in that** said calculating means include:

- for generating said first signal, a first capacitive element (73, 74) of determined capacitance;
- for generating said second signal, a second capacitive element (91) of substantially equal capacitance to the product of the capacitance of said first capacitive element (73, 74) by said first determined coefficient ($\alpha$);
- for generating said third signal, a third capacitive element (92) of substantially equal capacitance to the product of the capacitance of said first capacitive element (73, 74) by said second determined coefficient ($\beta$);
- for generating said fourth signal, a fourth capacitive element (93) of substantially equal capacitance to the product of said first capacitive element (73, 74) by said second and third determined coefficients ($\beta$ and $\gamma$).

5. Protective circuit according to any of claims 1 to 4, **characterised in that** said means for generating said diode voltages ($V_{BE1}$ to $V_{BE5}$) include bipolar transistors which are connected in series with current sources and whose base is connected to the collector.

6. Protective circuit according to any of claims 1 to 4, **characterised in that** said means for generating said diode voltages ($V_{BE1}$ to $V_{BE5}$) include three bipolar transistors (B1, B2, B3) whose base is connected to the collector, first (B1) and second (B3) of said transistors being each connected successively in series with two current sources (81, 82 and 84, 85), a third (B2) of said transistors being connected in series with a current source (B3).

7. Protective circuit according to any of claims 1 to 4, **characterised in that** said means for generating said diode voltages ($V_{BE1}$ to $V_{BE5}$) include two bipolar transistors whose base is connected to the collector, each of said transistors being connected successively in series with two current sources.

8. Protective circuit according to any of claims 1 to 7, **characterised in that** said interruption means (21) are formed of a pair of MOFSET power transistors (201, 202) connected in anti-series source to source, one or the other of the transistors (201, 202) being cut off to interrupt the flow of said current ($I_{CH}$, $I_{DCH}$).

9. Protective circuit according to any of claims 1 to 7, **characterised in that** said interruption means (21) are formed of a pair of MOFSET power transistors connected in anti-series drain to drain, one or the other of the transistors being cut off to interrupt the flow of said current ($I_{CH}$, $I_{DCH}$),

10. Protective circuit according to any of claims 1 to 7, **characterised in that** said interruption means (21) are formed by one MOFSET transistor including a counter-gate terminal adapted to be selectively connected to the source or the drain of said transistor.

**Patentansprüche**

1. Schutzschaltung (10), die dazu vorgesehen ist, eine wiederaufladbare Batterie (1) zu schützen, durch die ein Lade- oder Entladestrom ($I_{CH}$, $I_{DCH}$) fließen kann, wobei diese Schutzschaltung (10) umfasst:

- Messmittel (22), die dazu ausgelegt sind, mit der Batterie (1) in Reihe geschaltet zu werden und eine Messspannung ($V_M$) zu liefern, die den Strom ($I_{CH}$, $I_{DCH}$) repräsentiert, wobei diese Messspannung ($V_M$) eine erste Temperaturabhängigkeit aufweisen kann,
- Erfassungs- und Vergleichsmittel (30, 31, 32), die dazu ausgelegt sind, die Messspannung ($V_M$) und eine Referenzspannung ($V_{REF}$) zu empfangen und in Reaktion auf einen Vergleich der Referenzspannung ($V_{REF}$) und der Messspannung ($V_M$) ein Steuersignal (OVCR) zu erzeugen, wobei diese Referenzspannung ($V_{REF}$) eine zweite Temperaturabhängigkeit aufweisen kann; und
- Unterbrechungsmittel (21), die dazu ausgelegt sind, den Fluss des Stroms ($I_{CH}$, $I_{DCH}$) durch die Batterie (1) in Reaktion auf das Steuersignal (OVCR) zu steuern,

wobei diese Schutzschaltung (10) **dadurch gekennzeichnet ist, dass** die Erfassungs- und Vergleichsmittel (30, 31, 32) umfassen:

- Einstellmittel (32), die Mittel zum Erzeugen von Diodenspannungen ($V_{BE1}$ bis $V_{BE5}$) umfassen, um einen Kompensationswert zu liefern, der ermöglicht, die erste Temperaturabhängigkeit der Messspannung ($V_M$) und/oder die zweite Temperaturabhängigkeit der Referenzspannung ($V_{REF}$) zu kompensieren, und
- Rechenmittel, die kapazitive Elemente (73, 74, 91, 92, 93) und Umschaltorgane (SW1 bis SW6) umfassen, um in einer ersten Phase und in einer zweiten Phase die kapazitiven Elemente (73, 74, 91, 92, 93) wahlweise und sequentiell mit den Mitteln zum Erzeugen von Diodenspannungen ($V_{BE1}$ bis $V_{BE5}$) und mit den Anschlüssen (71, 72), an die die Messspannung ($V_M$) und die Referenzspannung ($V_{REF}$) angelegt werden, zu verbinden, derart, dass die Rechenmittel während der zweiten Phase das Steuersignal (OVCR) erzeugen, und
dass die Einstellmittel einen Kompensationswert erzeugen, der definiert ist durch die Summe:
- aus dem Produkt der Differenz zwischen der ersten und der zweiten Diodenspannung ($V_{BE1}$, $V_{BE2}$) mit einem ersten bestimmten Koeffizienten ($\alpha$) und
- aus dem Produkt eines zweiten vorgegebenen Koeffizienten ($\beta$) mit der Summe aus einer dritten Diodenspannung ($V_{BE3}$) und dem Produkt der Differenz zwischen einer vierten und einer fünften Diodenspannung ($V_{BE4}$, $V_{BE5}$) mit einem dritten vorgegebenen Koeffizienten ($\gamma$), wobei das Steuersignal (OVCR) die Summe aus der Differenz zwischen der Referenzspannung ($V_{REF}$) und der Messspannung ($V_M$) und dem Kompensationswert repräsentiert.

2. Schutzschaltung nach Anspruch 1, **dadurch gekennzeichnet, dass** die Unterbrechungsmittel (21) ebenfalls Messmittel (22) bilden, wobei die Messspannung ($V_M$) dann den Strom ($I_{CH}$, $I_{DCH}$) repräsentiert, der durch die Unterbrechungsmittel (21) fließt.

3. Schutzschaltung nach Anspruch 1, **dadurch gekennzeichnet, dass** die Rechenmittel so beschaffen sind, dass sie erzeugen:

- ein erstes Signal, das die Differenz zwischen der Referenzspannung ($V_{REF}$) und der Messspannung ($V_M$) repräsentiert;
- ein zweites Signal, das das Produkt aus der Differenz zwischen der ersten und der zweiten Diodenspannung ($V_{BE1}$, $V_{BE2}$) mit dem ersten gegebenen Koeffizienten ($\alpha$) repräsentiert;
- ein drittes Signal, das das Produkt aus der dritten Diodenspannung ($V_{BE3}$) mit dem zweiten bestimmten Koeffizienten ($\beta$) repräsentiert; und
- ein viertes Signal, das das Produkt aus der Differenz zwischen der vierten und der fünften Diodenspannung ($V_{BE4}$, $V_{BE5}$) mit dem zweiten und dem dritten bestimmten Koeffizienten ($\beta$ und $\gamma$) repräsentiert,

wobei diese Signale anschließend algebraisch addiert werden, um das Steuersignal (OVCR) zu erzeugen.

4. Schutzschaltung nach Anspruch 3, **dadurch gekennzeichnet, dass** die Rechenmittel umfassen:

- ein erstes kapazitives Element (73, 74) mit bestimmter Kapazität, um das erste Signal zu erzeugen,
- ein zweites kapazitives Element (91) mit einer Kapazität, die im Wesentlichen gleich dem Produkt aus der Kapazität des ersten kapazitiven Elements (73, 74) und dem ersten bestimmten Koeffizienten ($\alpha$) ist, um das zweite Signal zu erzeugen,
- ein drittes kapazitives Element (92) mit einer Kapazität, die im Wesentlichen gleich dem Produkt aus der Kapazität des ersten kapazitiven Elements (73, 74) mit dem zweiten bestimmten Koeffizienten ($\beta$) ist, um das dritte Signal zu erzeugen, und
- ein viertes kapazitives Element (93) mit einer Kapazität, die im Wesentlichen gleich dem Produkt aus der Kapazität des ersten kapazitiven Elements (73, 74) mit dem zweiten und dem dritten bestimmten Koeffizienten ($\beta$ und $\gamma$) ist, um das vierte Signal zu erzeugen.

5. Schutzschaltung nach einem der Ansprüche 1 bis 4, **dadurch gekennzeichnet, dass** die Mittel zum Erzeugen der Diodenspannungen ($V_{BE1}$ bis $V_{BE5}$) Bipolartransistoren enthalten, die mit Stromquellen in Serie geschaltet sind und deren Basis mit dem Kollektor verbunden ist.

6. Schutzschaltung nach einem der Ansprüche 1 bis 4, **dadurch gekennzeichnet, dass** die Mittel zum Erzeugen der Diodenspannung ($V_{BE1}$ bis $V_{BE5}$) drei Bipolartransistoren (B1, B2, B3) umfassen, deren Basis mit dem Kollektor verbunden ist, wobei der Erste (B1) und der Zweite (B3) der Transistoren jeweils nacheinander mit zwei Stromquellen (81, 82 und 84, 85) in Reihe geschaltet ist und wobei ein Dritter (B2) der Transistoren mit einer Stromquelle (83) in Serie geschaltet ist.

7. Schutzschaltung nach einem der Ansprüche 1 bis 4, **dadurch gekennzeichnet, dass** die Mittel zum Erzeugen der Diodenspannungen ($V_{BE1}$ bis $V_{BE5}$) zwei Bipolartransistoren umfassen, deren Basis mit dem Kollektor verbunden ist, wobei jeder dieser Transistoren nacheinander mit zwei Stromquellen in Serie geschaltet ist.

8.  Schutzschaltung nach einem der Ansprüche 1 bis 7, **dadurch gekennzeichnet, dass** die Unterbrechungsmittel (21) durch ein Paar von Leistungs-MOSFET-Transistoren (201, 202) gebildet sind, die Source mit Source antiseriell verbunden sind, wobei der eine oder der andere der Transistoren (201, 202) gesperrt wird, um den Fluss des Stroms ($I_{CH}$, $I_{DCH}$) zu unterbrechen.

9.  Schutzschaltung nach einem der Ansprüche 1 bis 7, **dadurch gekennzeichnet, dass** die Unterbrechungsmittel (21) durch ein Paar von Leistungs-MOSFET-Transistoren gebildet sind, die Drain mit Drain antiseriell verbunden sind, wobei der eine oder der andere der Transistoren gesperrt wird, um den Fluss des Stroms ($I_{CH}$, $I_{DCH}$) zu unterbrechen.

10.  Schutzschaltung nach einem der Ansprüche 1 bis 7, **dadurch gekennzeichnet, dass** die Unterbrechungsmittel (21) durch einen MOSFET-Transistor gebildet sind, der einen Gegen-Gate-Anschluss umfasst, der dazu ausgelegt ist, wahlweise mit der Source oder mit dem Drain des Transistors verbunden zu werden.

## Fig. 1

# Fig. 2

## Fig. 3

$V_M, V_{REF}$

## Fig. 4a

$V_{REF}$

$I > I_{PROT}$

$V_M$

(III)
(II)
(I)

$I_{PROT}$

(0)

$T_0$

$T$

$V_M, V_{REF}$

## Fig. 4b

$I_{PROT}$

$V_M$

(0)
(I)
(II)
(III)

$I < I_{PROT}$

$V_{REF}$

$T_0$

$T$

## Fig. 5

**EP 1 047 174 B1**

## RÉFÉRENCES CITÉES DANS LA DESCRIPTION

**Documents brevets cités dans la description**

- US 5689209 A
- US 5581170 A
- EP 0626582 A